(19) Europäisches Patentamt
European Patent Office
Office européen des brevets

(11) **EP 2 309 646 B1**

(12) **EUROPÄISCHE PATENTSCHRIFT**

(45) Veröffentlichungstag und Bekanntmachung des Hinweises auf die Patenterteilung:
**16.01.2013  Patentblatt 2013/03**

(51) Int Cl.:
**H03K 17/95** *(2006.01)*      **G01V 3/10** *(2006.01)*

(21) Anmeldenummer: **10014225.6**

(22) Anmeldetag: **21.02.2007**

(54) **Induktiver Näherungsschalter sowie Verfahren zum Betreiben eines solchen**

Inductive proximity switch and method for operating the same

Détecteur de proximité inductif et procédé d'utilisation de celui-ci

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **22.02.2006  DE 102006008211**
**23.01.2007  DE 102007003374**

(43) Veröffentlichungstag der Anmeldung:
**13.04.2011  Patentblatt 2011/15**

(62) Dokumentnummer(n) der früheren Anmeldung(en) nach Art. 76 EPÜ:
**07721942.6 / 1 987 592**

(73) Patentinhaber: **Pepperl & Fuchs GmbH**
**68307 Mannheim (DE)**

(72) Erfinder: **Kühn, Thomas**
**68219 Mannheim (DE)**

(74) Vertreter: **Schiffer, Axel Martin et al**
**Weber & Heim Patentanwälte**
**Irmgardstrasse 3**
**81479 München (DE)**

(56) Entgegenhaltungen:
**EP-A2- 0 479 078      WO-A-2006/021045**
**DE-A1- 10 012 830**

**Beschreibung**

Technisches Gebiet:

Die Erfindung betrifft einen induktiven Näherungsschalter, der einen stromgespeisten Schwingkreis, bestehend aus wenigstens einer Schwingkreis-Sendespule und einer Kapazität, aufweist, wobei die Schwingkreis-Sendespule ein magnetisches Wechselfeld erzeugt, welches in wenigstens einer Empfangsspule eine Gegeninduktionsspannung zu induzieren imstande ist, und der Schwingkreis durch einen in das Wechselfeld eindringenden oder sich entfernenden metallischen Auslöser in seinem Schwingungszustand beeinflussbar ist, mit einer Auswerteschaltung zur Gewinnung eines Schaltsignals aus der Änderung des Schwingungszustandes des Schwingkreises, wobei die Änderung der komplexen Kopplung zwischen den wenigstens zwei Spulen, Sendespule und Empfangsspule, unter Zuhilfenahme eines Hilfsspannungssignals bei Anwesenheit oder Abwesenheit des Auslösers als Schaltsignal auswertbar ist, gemäß dem Oberbegriff des Anspruchs 1. Ebenso betrifft die Erfindung ein Verfahren zum Betreiben eines derartigen induktiven Näherungsschalters gemäß dem Oberbegriff des Anspruchs 14.

Stand der Technik:

Induktive Näherungsschalter sind Sensoren, welche berührungsfrei auf Annäherung eines metallischen oder nichtmetallischen Gegenstandes, Target, d.h. ohne direkten Kontakt, reagieren. Zur Erfassung der Annäherung eines solchen Targets mittels eines induktiven Näherungsschalters ist durch die DE-AS 1 286 099 ein Wirbelstromverfahren bekannt geworden, bei welchem die durch den Auslöser in einem magnetlschen Wechselfeld hervorgerufenen Wirbelstromverluste ausgewertet werden. Hierzu erzeugt ein Oszillator mit einem LC-Schwingkreis ein magnetisches Wechselfeld, welches sich bei Auftreten von Wirbelstromverlusten ändert. Daraus resultiert eine Änderung der Schwingungsamplitude, welche Änderung bei Erreichen eines vorgegebenen Schaltwertes von einer Auswerteschaltung ausgewertet wird, welche zum Beispiel ein Relais oder sonstigen Lastschalter anzusteuern imstande ist. Nachteilig bei derartigen Näherungsschaltern ist die Tatsache, dass unterschiedlich leitende Auslöser zu unterschiedlich großen Wirbelstromverlusten und damit zu unterschiedlichen Ansprechabständen des Näherungsschalters führen.

Bei neueren induktiven Näherungsschaltern wird statt einer Spule ein Transformator mit Primärspule und Sekundärspule verwendet, die induktiv gekoppelt sind. Die Größe der Kopplung zwischen Primär- und Sekundärkreis wird als Kopplungsfaktor bezeichnet, der gewöhnlich zwischen 0 (keine Kopplung) und 1 (perfekte Kopplung) eingestellt werden kann, wobei der Kopplungsfaktor K die Größe der Gegeninduktivität M des Kreises bestimmt. Ein in den Schaltbereich des Näherungsschalters gebrachtes Target verändert die Kopplung. Die Kopplungsauswertung vermeidet eine Mehrzahl von Nachteilen, die mit Näherungsschaltern nur mit einer Spule verbunden sind; sie hat aber im Stand der Technik ihrerseits bisher den Nachteil, dass sie wegen des geringeren Signalpegels nicht einfach zu realisieren ist.

Bei induktiven Näherungsschaltern mit der Auswertung der Änderung der komplexen Kopplung bzw. der Transimpedanz zwischen wenigstens zwei Spulen (Primär- bzw. Sendespule und Sekundär- bzw. Empfangsspule), insbesondere Leiterplattenspulen, bei Anwesenheit eines metallischen Targets oder eines metallischen Auslösers treten des Weiteren folgende Hauptprobleme auf:

- Insbesondere bei erhöhten Schaltabständen sind extrem geringe relative Änderungen der Transimpedanz (maximal einige 1000ppm/K) gegeben, was eine direkte Auswertung der Sekundärspannung erheblich erschwert.
- Der Temperatureinfluss auf die Schaltungsanordnung, insbesondere durch die Temperaturabhängigkeit des Realteils der Sendespulenimpedanz (Cu-Verluste: Tk=+3800 ppm/K) ist erheblich.
- Bei Verwendung von Leiterplatten-Spulenanordnungen und kleinen Bauformen ergeben sich ebenfalls nur kleine Sendespulen- und Transimpedanzen. Zur Realisierung hinreichend hoher Spannungen müssen also entsprechend große Ströme fließen.

Aus dem Stand der Technik ist es deshalb bekannt, eine Stromeinprägung in die Primärspule und eine direkte Auswertung der Sekundärspannungs- bzw. Transimpedanzänderungen z.B. mit Hilfe eines mitgekoppelten Verstärkers (Oszillator), zu realisieren. Hierdurch wird die Unabhängigkeit vom Realteil der Sendespulenimpedanz erreicht. Dadurch allerdings ergibt sich das weitere Problem, dass kleine relative Änderungen der Transimpedanz extreme Stabilität des Verstärkers (dv/v maximal einige 100ppm/K) und eine hochlineare Stromquelle erfordern. Bei LP-Spulen sind wegen der kleinen Impedanzen nur kleine Spannungsamplituden möglich, da die mögliche Stromamplitude in der Praxis stark limitiert ist.

Des Weiteren ist es bekannt, eine Stromeinspeisung in einen (Parallel-) Schwingkreis zu realisieren, gebildet aus der Primärspule und einer Kapazität. Damit wird der Vorteil erreicht, dass die Stromquelle gegen die weitaus höhere Resonanzimpedanz des Kreises arbeitet, womit größere Amplituden erzielt werden. Nachteilig ist bei dieser Lösung, dass die Resonanzimpedanz bzw. die Primärspannung stark temperaturabhängig (Tk=-3800 ppm/K) ist. Da Sekundär- und Primärspannung in guter Näherung proportional sind, zeigt auch die Sekundärspannung diese Temperaturabhängigkeit. Die Temperatureinflüsse werden also das Nutzsignal, das ist die targetinduzierte Sekundärspannungsänderung, bei weitem überdecken.

Zur Anhebung der relativen Änderung des Ausgangssignals ist es aus der EP 0 479 078A sowie der US 6657323 bekannt geworden, von der Sekundärspannung eine "Referenzspannung" zu subtrahieren, welche durch eine zweite Sekundärspule gebildet wird, die räumlich getrennt angeordnet ist und vom Auslöser nahezu unbeeinflusst bleibt. Hierzu geht der Gegenstand der EP 0 479 078A von einem induktiven Näherungsschalter mit einem Oszillator aus, der eine Sendespule speist, die ein magnetisches Wechselfeld erzeugt, wobei der Oszillator durch einen in das Wechselfeld eindringenden metallischen Auslöser in seinem Schwingungszustand beeinflusst wird, mit einer Auswerteschaltung zur Gewinnung eines Schaltsignals aus der Änderung des Schwingungszustandes. Im Wechselfeld befinden sich zwei Sensorspulen in unmittelbarer Differenzschaltung zur Erfassung der Differenz der in den beiden Sensorspulen induzierten Spannungen, wobei die Sensorspulen durch ihre räumliche Lage zueinander und durch die jeweiligen Windungszahlen derart ausgebildet sind, dass die Differenzwechselspannung beim gewünschten Ansprechabstand zu null wird. Die Differenzwechselspannung ist an den Eingang des Oszillatorverstärkers des Oszillators derart zurückgeführt, dass bei einer Differenzwechselspannung null der Oszillator seinen Schwingungszustand sprunghaft ändert. Die Sendespule ist als Induktivität des LC-Schwingkreises des Oszillators geschaltet, wobei der Eingang des Oszillatorverstärkers hochohmig ist und die beiden Sensorspulen mit entgegengesetzter Polarisierung in Reihe zwischen einem Spannungsteiler und dem hochohmigen Eingang des Oszillatorverstärkers geschaltet sind. Auf diese Weise erhält man eine deutlich kleinere Differenzspannung, die nun eine wesentlich größere relative Änderung aufweist. Mit der Differenzbildung durch die antiserielle Zusammenschaltung der beiden Spulen ist allerdings der Nachteil verbunden, dass die Differenzspannung wieder einer erheblichen Temperaturabhängigkeit unterliegt, nämlich zum Beispiel Tk=-3800 ppm/K. Eine Eigenkompensation der Temperaturabhängigkeit ist also nicht zu erwarten. Der Temperatureinfluss wird entsprechend der Zunahme der relativen Änderung immerhin reduziert.

Durch die DE19611810A1 ist des Weiteren ein berührungslos arbeitender Näherungsschalter mit einem durch von außen herangeführte metallische Gegenstände beeinflussbaren Schwingkreis und mit einer Auswerteeinrichtung zur Gewinnung eines Schaltsignals aus einem die Änderung des Schwingungszustands des Schwingkreises beschreibenden Ausgangssignal bekannt geworden. Der Schwingkreis ist eine Schwingkreisbrücke mit wenigstens zwei Kondensatoren und mit wenigstens zwei durch die von außen herangeführten Gegenstände unterschiedlich beeinflussbaren Spulen, wobei die Brückendiagonalspannung ausgewertet wird.

Des Weiteren ist durch die DE 19843749A1 ein Verfahren zur Auswertung kleiner Änderungen einer Kapazität unter Verwendung einer elektrischen Brückenschaltung bekannt geworden, in deren Brückenzweigen sich als Blindwiderstände wenigstens je ein Kondensator befindet und die Brücke mit einer Wechselspannung als Brückenspeisespannung beaufschlagt wird und wenigstens einer der Kondensatoren veränderbar ist. Die beiden Brückenzweigspannungen werden getrennt nach der jeweiligen Brückenhälfte gleichgerichtet, wobei die Brückendiagonalspannung erst nach der Gleichrichtung der beiden Brückenzweigspannungen als sich entsprechend der Änderung der Kapazität ändernde Gleichspannung ausgewertet wird.

Technische Aufgabe:

Der Erfindung liegt die **Aufgabe** zugrunde, einen induktiven Näherungsschalter zu schaffen, der über einen weiten Temperaturbereich von wenigstens -25 GradC bis +100 GradC einen konstanten Abstand hinsichtlich seines Ansprechverhaltens aufweist und der des Weiteren als Allmetallschalter, der auf Auslöser aus Eisen- und Nichteisenmetallen bei demselben Ansprechabstand anspricht, verwendet werden kann; ebenso soll der Näherungsschalter als selektiver Schalter, der entweder nur auf Eisen- oder Nichteisenmetalle anspricht, eingesetzt werden können.

Offenbarung der Erfindung und deren Vorteile:

Diese Aufgabe wird durch einen induktiven Näherungsschalter mit den Merkmalen des Anspruchs 1 gelöst.
In allgemeiner Weise kann somit die Differenzspannung, bei zur Verfügungstellung eines eingeprägten Stromes in den Schwingkreis, direkt in geeigneter Weise abgenommen und weiterverarbeitet werden.
In weiterer, bevorzugter erfindungsgemäßer Ausgestaltung des induktiven Näherungsschalters weist derselbe einen stromgespeisten Oszillator auf, bestehend aus wenigstens einer Schwingkreis-Sendespule und einer Kapazität, wobei die Schwingkreis-Sendespule ein magnetisches Wechselfeld erzeugt, welches in wenigstens einer Empfangsspule eine Gegeninduktionsspannung zu induzieren imstande ist, und der Oszillator durch einen in das Wechselfeld eindringenden oder sich entfernenden metallischen Auslöser in seinem Schwingungszustand beeinflussbar ist, mit einer Auswerteschaltung zur Gewinnung eines Schaltsignals aus der Änderung des Schwingungszustandes des Oszillators, wobei die Änderung der komplexen Kopplung zwischen den wenigstens zwei Spulen, Sendespule und Empfangsspule, unter Zuhilfenahme eines Hilfsspannungssignals bei Anwesenheit oder Abwesenheit des Auslösers als Schaltsignal auswertbar ist, wobei die Differenzspannung, in Abwandlung zum Anspruch 1, einem Transkonduktanzverstärker zugeführt ist zur Gewinnung und Rückführung des den Schwingkreis des Oszillators speisenden, der Differenzspannung proportionalen Stromes, und die Schwingkreisspannung der Auswerteschaltung zum Erhalt des Schaltsignals zugeführt ist.

Der erfindungsgemäße induktive Näherungsschalter besitzt dadurch den Vorteil, dass derselbe eine nahezu perfekte Temperaturunabhängigkeit und gleichzeitig eine große relative Änderung der Differenzspannung bei der Annäherung eines Targets aufweist.

Dies kann beim erfindungsgemäßen induktiven Näherungsschalter, ob nur mit Schwingkreis oder mit Oszillator, in vorteilhafter Weise dadurch erreicht werden, dass mittels des vorgebbaren Verhältnisses zwischen Hilfsspannungssignal und Schwingkreisspannung die Differenzspannung so wählbar ist, dass die Differenzspannung entweder bei Resonanz des Schwingkreises bzw. in der Resonanzamplitude der Schwingkreisspannung temperaturunabhängig wird oder für eine Amplitude der Schwingkreisspannung temperaturunabhängig ist, welche symmetrisch zur Resonanzfrequenz des Schwingkreises auf den Resonanzflanken liegt.

In weiterer vorteilhafter Ausgestaltung eines derartigen erfindungsgemäßen Näherungsschalters ist mittels einer Stromquelle dem Schwingkreis ein Speisestrom eingeprägt und die Differenzspannung einem Verstärker zugeführt, an dessen Ausgang der eine Eingang eines Multiplizierers angeschlossen ist, und an dessen anderen Eingang die Phaseninformation des den Schwingkreis speisenden Stromes, vorzugsweise mittels eines Phasenschiebers beeinflusst, gelegt ist, wobei der Ausgang des Multiplizierers der Auswerteschaltung zum Erhalt des Schaltsignals zugeführt ist.

Diese Temperaturunabhängigkeit wird sowohl bei einem Schwingkreis mit eingeprägtem Speisestrom als insbesondere auch bei einem Oszillator mit rückgekoppeltem Speisestrom erzielt.

In weiterer vorteilhafter Ausgestaltung des erfindungsgemäßen Näherungsschalters, bei welchem der Schwingkreis zu einem Oszillator geschaltet ist, ist der Transkonduktanzverstärker ein solcher mit wählbarer Steilheit.

In einer weiteren vorteilhaften Ausgestaltung eines induktiven Näherungsschalters, die nicht zur Erfindung gehört, ist zur Gewinnung des Hilfsspannungssignals als Teilspannung in einem vorgebbaren Verhältnis aus der Schwingkreisspannung des Schwingkreises die Schwingkreisspannung auf die Eingänge eines Verstärkers mit vorgebbarer Verstärkung gelegt, dessen Ausgangssignal, entweder gegen Masse oder gegen ein Potential, das Hilfsspannungssignals bildet, wobei an den Ausgang des Verstärkers das eine Ende der Empfangsspule gelegt ist, an deren anderen Ende, gegen Masse oder gegen ein Potential, die Differenzspannung erhalten wird.

Zur Gewinnung des Hilfsspannungssignals als Teilspannung in einem vorgebbaren Verhältnis aus der Schwingkreisspannung des Schwingkreises ist diesem erfindungsgemäß ein komplexer Spannungsteiler aus einer Reihenschaltung zweier komplexer Widerstände parallel geschaltet, wobei das Hilfsspannungssignal über dem zweiten komplexen Widerstand abfällt und an den Mittelpunkt des Spannungsteilers das eine Ende der Empfangsspule gelegt ist, an deren anderen Ende die Differenzspannung erhalten wird.

Somit teilt der komplexe Spannungsteiler mit wenigstens den komplexen Widerständen $Z_1$ und $Z_2$ die Kreis- oder Primärspannung in einem einstellbaren Verhältnis v, so dass durch die entsprechende Wahl des Teilerverhältnisses

$$v = Z_2/(Z_1 + Z_2)$$

eine Differenzspannung $u_D$ gegen Masse, Ground, erhalten wird, welche sowohl eine nahezu perfekte Temperaturunabhängigkeit als auch eine große relative Änderung bei der Annäherung des Targets aufweist. Dadurch ist ein eigenkompensiertes System realisierbar. Ebenso ist höchst vorteilhaft keine zweite, abgesetzte Sekundärspule erforderlich.

Erfindungsgemäß ist die Reihenschaltung der beiden komplexen Widerstände des Spannungsteilers eine Reihenschaltung von zwei Kondensatoren, wobei das Hilfsspannungssignal über dem zweiten der beiden Kondensatoren abfällt.

Die Kapazität des Schwingkreises ist erfindungsgemäß ganz oder teilweise von den Kondensatoren oder einem der Kondensatoren gebildet. Sie kann auch teilweise von der Eigenkapazität der Sendespule gebildet sein.

Die Anwendung der vorgenannten Netzwerkgestaltungen mit einem Verstärker oder einem vorzugsweise komplexen Spannungsteiler sind ebenfalls unabhängig davon, ob ein Schwingkreis mit eingeprägtem Speisestrom oder ein Oszillator mit rückgekoppeltem Speisestrom eingesetzt wird.

In einer weiteren Ausgestaltung des erfindungsgemäßen Näherungsschalters ist zur Gewinnung des Hilfsspannungssignals als Teilspannung in einem vorgebbaren Verhältnis aus der Schwingkreisspannung des Schwingkreises diesem ein komplexer Spannungsteiler aus einer Reihenschaltung zweier komplexer Widerstände parallel geschaltet, wobei das Hilfsspannungssignal über dem zweiten komplexen Widerstand abfällt und gleichzeitig an zwei Signaleingänge eines Impedanzwandlers gelegt ist, und das eine Ende der Empfangsspule ist an den Ausgang des Impedanzwandlers gelegt und am Ausgang der Empfangsspule, gegen Masse oder gegen ein Potential, wird die Differenzspannung erhalten. Der Mittenabgriff des Spannungsteilers ist somit auf den einen Eingang des Impedanzwandlers gelegt, auf dessen anderen Eingang der gemeinsame Fußpunkt von Schwingkreis und Spannungsteiler, also im einfachsten Fall an Masse, gelegt ist, wobei das Ausgangssignal des Impedanzwandlers die Hilfsspannung liefert.

In weiterer Ausgestaltung des Näherungsschalters ist wenigstens einer der beiden komplexen Widerstände des komplexen Spannungsteilers einstellbar, so dass die Schwingkreisspannung des Schwingkreises in einem einstellbaren Verhältnis geteilt und damit eine einstellbare Differenzspannung am Ausgang der Empfangsspule erhalten wird.

In weiterer Ausgestaltung des Näherungsschalters bilden Sendespule und Empfangsspule ein Planarspulensystem. (A13) Ebenso können Sendespule und Empfangsspule als Leiterplattenspulen ausgestaltet sein.

In weiterer Ausgestaltung des Näherungsschalters wird die Schwingkreisspannung gleichgerichtet und einem Schwellwertdiskriminator zum Erhalt des Schaltsignals zugeführt.

Verfahrensmäßig wird die vorgenannte Aufgabe zum Betrieb eines induktiven Näherungsschalters durch das Verfahren mit den Merkmalen des Anspruchs 14 gelöst.

In weiterer vorteilhafter Ausgestaltung des erfindungsgemäßen Verfahrens und bei Verwendung eines Oszillators mit rückgekoppelter Stromeinspeisung wird die Differenzspannung einem Transkonduktanzverstärker zugeführt, dessen, der Differenzspannung proportionaler Strom in den Schwingkreis des Oszillators rückgespeist wird, wobei die Schwingkreisspannung der Auswerteschaltung zum Erhalt des Schaltsignals zugeführt wird.

Verfahrensgemäß kann auf diese Weise die Schwingkreisspannung des Schwingkreises in einem einstellbaren Verhältnis geteilt und dadurch eine einstellbare Differenzspannung am Ausgang der Empfangsspule erhalten werden.

In weiterer erfindungsgemäßer Ausgestaltung des Verfahrens wird mittels des vorgebbaren Verhältnisses zwischen Hilfsspannungssignal und Schwingkreisspannung die Differenzspannung so gewählt, dass diese entweder bei Resonanz des Schwingkreises bzw. in der Resonanzamplitude der Schwingkreisspannung temperaturunabhängig wird oder für eine Amplitude der Schwingkreisspannung temperaturunabhängig wird, welche symmetrisch zur Resonanzfrequenz des Schwingkreises auf den Resonanzflanken liegt.

Kurzbezeichnung der Zeichnung, in der zeigen:

Figur 1 ein Beispiel einer elektrischen Schaltung T einer allgemeinen Ausführungsform eines Netzwerks mit einem komplexen Spannungsteiler aus einer Reihenschaltung zweier komplexer Widerstände ($Z_1$, $Z_2$) zur Gewinnung des Hilfsspannungssignals $u_{Hsp}$

Figur 2 eine weitere Schaltung für einen erfindungsgemäßen Näherungsschalter, in welcher der komplexe Spannungsteiler aus einer Reihenschaltung von zwei Kondensatoren gebildet ist

Figur 3 ein weiteres Beispiel einer Schaltung T mit einem Impedanzwandler zur Erzeugung des Hilfsspannungssignals $u_{Hsp}$

Figur 4 ein weiteres Beispiel einer Schaltung T mit einem Verstärker zur Erzeugung des Hilfsspannungssignals $u_{Hsp}$

Figur 5 eine Schaltung eines Oszillators mittels Transkonduktanzverstärker, bei welchem die Erzeugung des Hilfsspannungssignals $u_{Hsp}$ gemäß dem elektrischen Netzwerk T der Figur 2 erfolgt

Figur 6 eine Schaltung eines Oszillators mittels Transkonduktanzverstärker, bei welchem die Erzeugung des Hitfsspannungssignals $u_{Hsp}$ gemäß dem elektrischen Netzwerk T der Figur 1 erfolgt

Figur 7 ein Beispiel mit Zahlenwerten der Schaltungskomponenten für die Temperaturkompensation der Differenzspannung $u_D$ gemäß dem Netzwerk T der Figur 2

Figur 8 eine Kurvenschar betreffend die Temperaturkompensation der Differenzspannung $u_D$ bei Amplitudenresonanz

Figur 9 eine Kurvenschar betreffend die Temperaturkompensation der Differenzspannung $u_D$ auf den Flanken

Figur 10 ein weiteres Beispiel einer Schaltung, in der die Spule des Schwingkreises als induktiver Teiler zur Gewinnung der Hilfs- bzw. Differenzspannung nutzbar ist und

Figur 11 ein Beispiel einer Schaltung in Anlehnung an Figur 10, wobei hier die aus der Spulenanzapfung gewonnene Spannung, entsprechend der in Figur 3 im Punkt M gewonnenen Spannung, verstärkt wird.

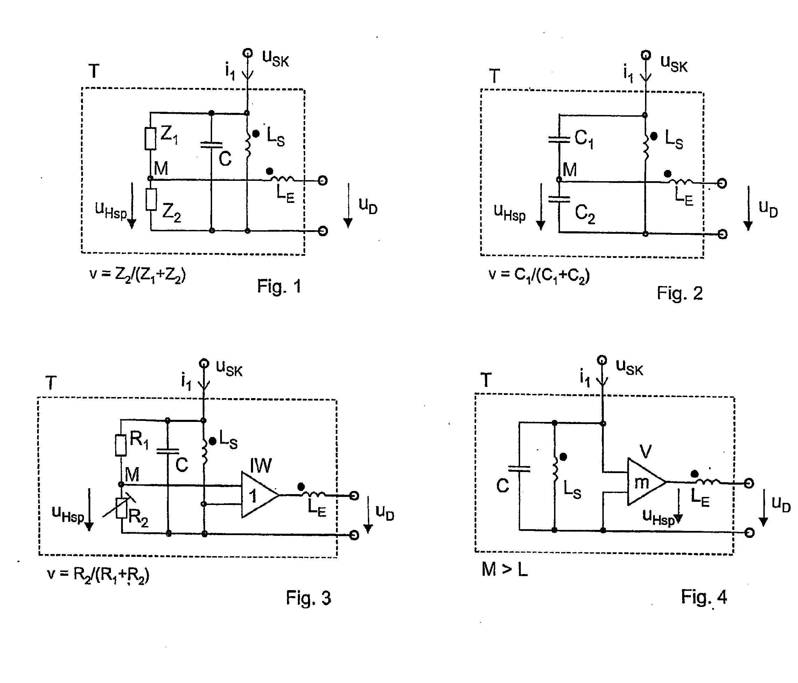

In Figur 1 ist innerhalb der punktierten Linienführung ein Netzwerk T dargestellt, welches einen Schwingkreis aufweist, der vorzugsweise der Schwingkreis eines Oszillators eines induktiven Näherungsschalters ist, wobei der Schwingkreis aus einer Sendespule $L_S$ und einer Kapazität C besteht. Die Sendespule $L_S$ erzeugt ein magnetisches Wechselfeld, welches in einer Empfangsspule $L_E$ in bekannter Weise eine Gegeninduktionsspannung induziert, die u.a. vom Verhältnis der beiden Spulenwindungszahlen und der geometrischen Anordnung (Kopplung) abhängt. Das magnetische Wechselfeld der Sendespule $L_S$ des Schwingkreises $L_S$, C wird bei Annäherung oder Entfernung eines metallischen Auslösers verändert, so dass sich die Gegeninduktionsspannung in der Empfangsspule $L_E$ ändert. Dadurch ändert sich die Ausgangsspannung der Empfangsspule $L_E$, Differenzspannung $u_D$ genannt, was im Nachfolgenden näher erklärt ist.

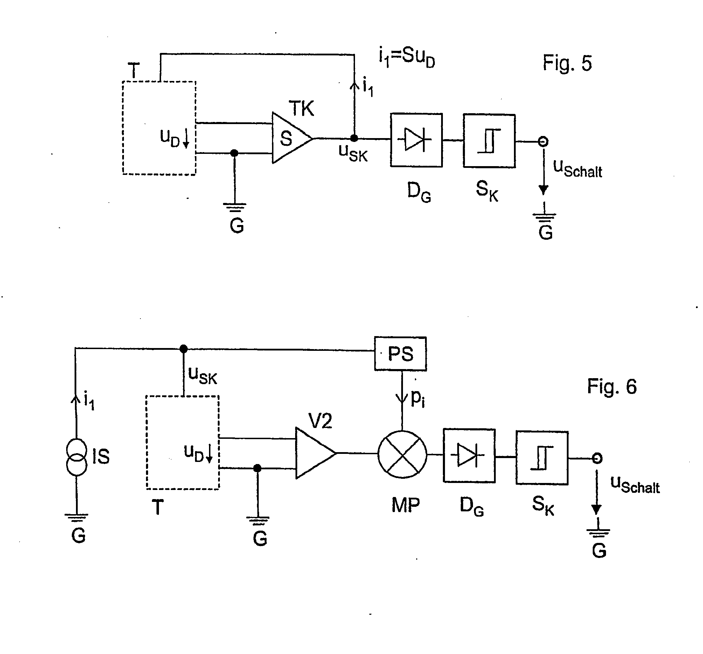

Zur Gewinnung eines Hilfsspannungssignals $u_{Hsp}$ als Teilspannung aus der Schwingkreisspannung $u_{SK}$ des Schwingkreises $L_S$, C ist parallel demselben ein komplexer Spannungsteiler, bestehend aus den beiden komplexen Widerständen $Z_1$ und $Z_2$, gelegt, wobei die über dem zweitgenannten komplexen Widerstand $Z_2$ des Spannungsteilers abfallende Spannung die Hilfsspannung $u_{Hsp}$ oder das Hilfsspannungssignal $u_{Hsp}$ ist. An den Mittenpunkt M zwischen den beiden komplexen Widerständen $Z_1$ und $Z_2$ ist das eine Ende der Empfangsspule $L_E$ gelegt, so dass das Hilfsspannungssignal $u_{Hsp}$ von der in der Empfangsspule $L_E$ induzierten Gegeninduktionsspannung subtrahiert bzw. zu dieser addiert wird und damit am Ausgang der Empfangsspule $L_E$, entweder gegen Masse G oder gegen ein Potential, die vorgenannte, induzierte Differenzspannung $u_D$ erhalten wird, welche gegenüber der in der Empfangsspule $L_E$ induzierten Gegeninduktionsspannung betragsmäßig um das Hilfsspannungssignal $u_{Hsp}$ vermindert ist. Die Differenzspannung $u_D$ wird, wie in den Figuren 5 und 6 näher beschrieben, in geeigneter Weise weiterverarbeitet. Mit dem Bezugszeichen $i_1$ ist der Speisestrom des Schwingkreises $L_S$, C bezeichnet, der entweder Teil eines Oszillators gemäß den Figuren 5 und 6, in welchen der Speisestrom $i_1$ rückgekoppelt ist, oder die Bezeichnung benennt den eingeprägten Speisestrom $i_1$ in den Schwingkreis $L_S$, C, ohne dass derselbe als Oszillator geschaltet ist.

Vorzugsweise ist die Impedanz des Spannungsabgriffs der Differenzspannung $u_D$ größer als $Z_2$. Aus der Schaltung ergibt sich ein Teilerverhältnis v für den komplexen Spannungsteiler zu:

$$v = Z_2/(Z_1 + Z_2).$$

Eine allgemeinere Schaltung zur Realisierung der Erfindung ist anhand des Netzwerkes T der Figur 4 erläutert. Es wird das Hilfsspannungssignals $u_{Hsp}$ als Teilspannung aus der Schwingkreisspannung $u_{SK}$ des Schwingkreises $L_S$, C gewonnen, wobei hierzu die Schwingkreisspannung $u_{SK}$ an die Signaleingänge eines Verstärkers V mit der Verstärkung m gelegt ist, dessen Ausgangssignal, entweder gegen Masse G oder gegen ein Potential, das Hilfsspannungssignal $u_{Hsp}$, ebenfalls entweder gegen Masse G oder gegen ein Potential, bildet. An den Ausgang des Verstärkers V ist das eine Ende der Empfangsspule $L_E$ gelegt, womit das Hilfsspannungssignal $u_{Hsp}$ von der in der Empfangsspule $L_E$ durch die Sendespule $L_S$ induzierten Gegeninduktionsspannung subtrahiert bzw. zu dieser addiert wird und am Ausgang der Empfangsspule $L_E$, gegen Masse G oder gegen ein Potential, die Differenzspannung $u_D$ erhalten wird. Die Differenzspannung $u_D$ wird, wie in den Figuren 5 und 6 näher beschrieben, in geeigneter Weise weiterverarbeitet.

Figur 2 zeigt innerhalb des Netzwerkes T eine weitere Schaltung für einen erfindungsgemäßen Näherungsschalter, in welcher der komplexe Spannungsteiler aus einer Reihenschaltung von zwei Kondensatoren $C_1$ und $C_2$ besteht, ansonsten entspricht die Schaltung der Figur 2 derjenigen in Figur 1. Damit ergibt sich für das Teilerverhältnis v des Spannungsteilers für diesen Fall:

$$v = C_1/(C_1 + C_2).$$

Die Hilfsspannung $u_{Hsp}$ oder das Hilfsspannungssignals $u_{Hsp}$ fällt über dem Kondensator $C_2$, das ist in der Figur 2 der zweite Kondensator des Spannungsteilers, ab. Wie vorstehend geschildert ist an den Mittenpunkt M zwischen den beiden Kondensatoren $C_1$ und $C_2$ das eine Ende der Empfangsspule $L_E$ gelegt, so dass das Hilfsspannungssignal $u_{Hsp}$ von der in der Empfangsspule $L_E$ induzierten Gegeninduktionsspannung subtrahiert bzw. zu dieser addiert wird. Damit wird am Ausgang der Empfangsspule $L_E$, entweder gegen Masse G oder gegen ein Potential, eine induzierte Differenzspannung $u_D$ erhalten, welche betragsmäßig um das Hilfsspannungssignal $u_{Hsp}$ vermindert ist. Die Differenzspannung $u_D$ wird wiederum, wie in den Figuren 5 und 6 näher beschrieben, in geeigneter Weise weiterverarbeitet.

Am Ausgang der Empfangsspule $L_E$ wird das Differenzsignal $u_D$ erhalten. Die Besonderheit ist hier, dass die Kapazität des Schwingkreises in die Kapazität $C_1$ bzw. in die Kapazitäten $C_1 + C_2$ eingerechnet werden kann, so dass der Schwingkreis aus der Sendespule $L_S$ und einer oder der Reihenschaltung der Kapazitäten $C_1$, $C_2$ gebildet werden kann.

Zur Erzeugung des Hilfsspannungssignals $u_{Hsp}$ zeigt das Netzwerk T der Figur 3 eine weitere beispielhafte Schaltung mit einem Impedanzwandler IW. Hier besteht der Spannungsteiler aus zwei, vorzugsweise ohmschen, Widerständen $R_1$ und $R_2$, wobei der zweitgenannte Widerstand $R_2$ veränderbar ist. Über diesen zweiten Widerstand $R_2$ fällt die Hilfsspannung $u_{Hsp}$ ab, welche über die Signaleingänge des Impedanzwandlers IW an denselben angelegt ist. An den im Vergleich zu seinem Eingang niederohmigen Ausgang des Impedanzwandlers IW ist das eine Ende der Empfangsspule $L_E$ gelegt, wobei das Differenzsignal $u_D$ am anderen Ende der Empfangsspule $L_E$, vermindert um das Hilfsspannungssignal $u_{Hsp}$, entweder gegen Masse oder gegen ein Potential, abgegriffen wird. Die Differenzspannung $u_D$ wird wiederum, wie in den Figuren 5 und 6 näher beschrieben, in geeigneter Weise weiterverarbeitet.

Das Teilerverhältnis v wird hier gebildet durch:

$$v = R_2/(R_1 + R_2).$$

Die vorbeschriebenen Netzwerke T der Figuren 1 bis 4 können vorteilhaft in Schwingkreisen mit eingeprägtem Speisestrom $i_1$ verwendet werden, wenn das an der Empfangsspule $L_E$ anstehende Differenzspannungssignal $u_D$ in geeigneter Weise weiterverarbeitet wird.

Die Figuren 5 und 6 zeigen bevorzugte Ausführungsbeispiele eines erfindungsgemäßen induktiven Näherungsschalters einschließlich einer Auswerteschaltung zum Erhalt eines Schaltsignals $u_{Schalt}$, bei denen eines der Netzwerke T gemäß der Figuren 1 bis 4 wesentlicher Teil der Schaltung ist.

In der Figur 5 ist eines der Netzwerke T mit einem Transkonduktanzverstärker TK mit Steilheit S zusammengeschaltet. Das Differenzsignal $u_D$ wird auf den einen Eingang des Transkonduktanzverstärkers TK gelegt, dessen weiterer Eingang entweder auf Masse G oder ein vorgegebenes Potential gelegt ist. Am Ausgang des Transkonduktanzverstärkers steht ein Speisestrom $i_1$, $i_1 = Su_D$, zur Verfügung, welcher Ausgang auf den Schwingkreis des Netzwerkes T, bestehend zum Beispiel aus $L_S$, C, $C_1$, $C_2$, $Z_1$, $Z_2$, $R_1$, $R_2$ zur Bildung eines Oszillators zurückgekoppelt ist und damit einen oszillatorisch arbeitenden Mitkopplungsverstärker darstellt. Am Ausgang des Transkonduktanzverstärkers TK steht somit die sich gemäß $u_D$ ändernde Schwingkreisspannung $u_{SK}$ zur Verfügung, welche über die Rückkopplungsstrecke auf einen Diodengleichrichter $D_G$ gelegt ist, dessen Ausgangssignal einem Schwellwertdiskriminator $S_K$ mit einer vorgegebenen Referenzspannung zugeführt ist, an dessen Ausgang bei Erreichen der Referenzspannung das Schaltsignal $u_{Schalt}$ erhalten wird. Statt eines Diodengleichrichters kann auch ein AD-Wandler Verwendung finden.

In der Figur 6 ist eines der Netzwerke T mit einem Verstärker V2 zusammen geschaltet mit dem Unterschied, dass hier der Schwingkreis des Netzwerkes T, bestehend zum Beispiel aus $L_S$, C, $C_1$, $C_2$, $Z_1$, $Z_2$, $R_1$, $R_2$, nicht Teil eines Oszillators ist. Sondern eine Stromquelle IS prägt einen Strom $i_1$ in den Schwingkreis des Netzwerkes T ein, welches am Ausgang, wie vorbeschrieben, das Differenzspannungssignal $u_D$ ausgibt. Dieses wird auf den Eingang eines Verstärkers V2 gelegt, dessen weiterer Eingang entweder auf Masse G oder ein vorgegebenes Potential gelegt ist. Der Ausgang des Verstärkers V2 ist auf einen Multiplizierer geführt, welcher als Synchrongleichrichter arbeitet. Denn gleichzeitig wird dem Multiplizierer über einen Phasenschieber PS die Phaseninformation pi des Speisestromes $i_1$ zugeführt. Das Ausgangssignal des Multiplizierers MP ist wiederum auf den Diodengleichrichter $D_G$ gelegt, dessen Ausgangssignal, wie vorbeschrieben, dem Schwellwertdiskriminator $S_K$ zugeführt wird zum Erhalt des Schaltsignal $u_{Schalt}$.

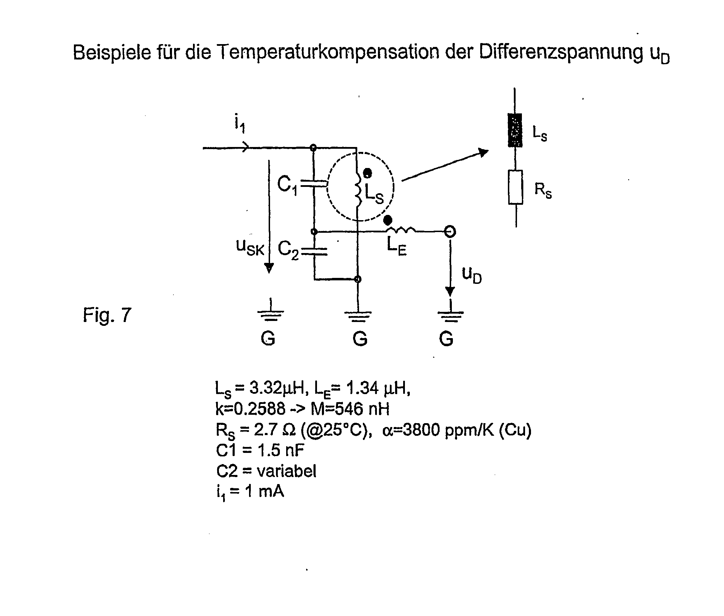

In Figur 7 ist ein Netzwerk mit den dazugehörigen Zahlenwerten der Schaltungskomponenten für die Temperaturkompensation der Differenzspannung $u_D$ angegeben, weiches dem Netzwerk gemäß der Figur 2 entspricht:

$L_S$ = 3,32 $\mu$H, $L_E$ = 1,34 $\mu$H,
k = 0,2588-> M = 546 nH
$R_S$ = 2,7 Ohm (@25GradCelsius), a = 3800 ppm/K (Cu)
$C_1$ = 1,5 nF, $C_2$ = variabel; $i_1$ = 1 mA.

Bei Verwendung beispielsweise der vorgenannten Werte der Schaltungskomponenten in einem induktiven Näherungsschalter gemäß der Schaltung der Figur 5 zeigt dieser eine nahezu perfekte Temperaturunabhängigkeit.

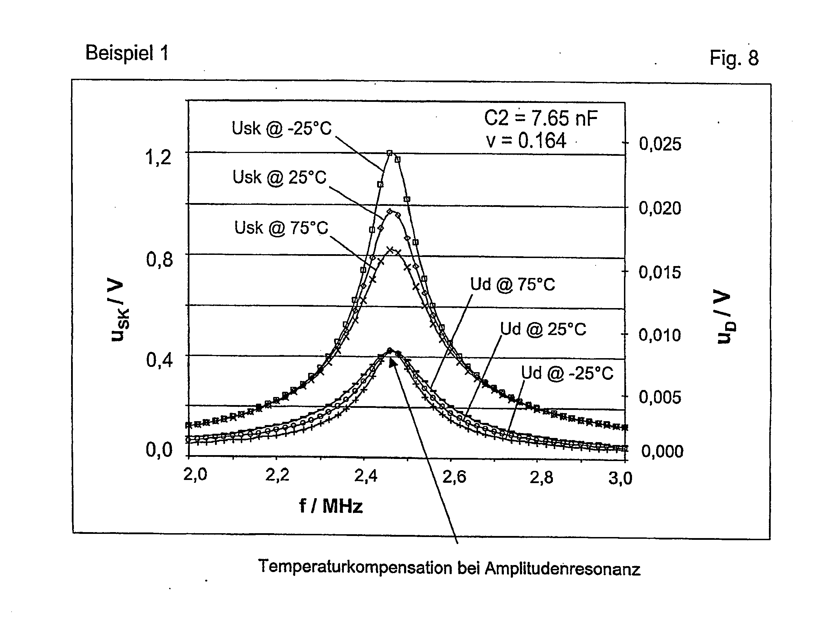

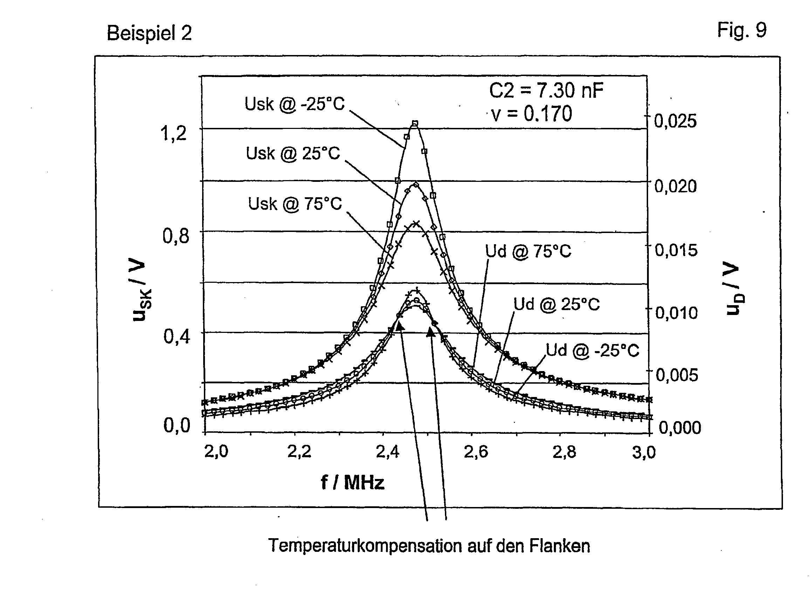

Die Beispiele 1 und 2 in den Figuren 8 bzw. 9 zeigen die Temperaturkompensation der Netzwerke T bei Amplitudenresonanz bzw. bei einer Temperaturkompensation auf den Flanken gemäß der Beschaltung mit Bauelementen gemäß der Figur 7.

Der jeweilige Kondensator $C_2$, über dem das Hilfsspannungssignals $u_{Hsp}$ abfällt, hat eine Größe von $C_2$ = 7,65 nF bzw. von 7,30 nF. Es ergibt sich damit ein v = $C_1/(C_1 + C_2)$ = 0,164 bzw. 0,170. Auf der Ordinate ist die Schwingkreisspannung $u_{SK}$/V, auf der Abszisse die Schwingkreisfrequenz f/MHz aufgetragen. Augenscheinlich ist zu erkennen, dass beim Betrieb des Schwingkreises bei unterschiedlichen Temperaturen (-25GradCelsius, 25GradC, 75GradC), bei denen natürlich unterschiedliche Resonanzamplituden erhalten werden, die zugehörigen Differenzspannungssignale $u_D$ ein praktisch identisches Amplitudenmaximum aufweisen.

Vergleichbares gilt gemäß Figur 9, Beispiel 2, bei der Temperaturkompensation auf den Flanken. Die zu den temperatur-unterschiedlichen Schwingkreisspannungen gehörenden Differenzspannungssignale $u_D$ schneiden sich jeweils in zwei Punkten, nämlich cirka bei Y=4,65 ·10$^{-1}$ $u_{SK}$/V, X=2,435 f/MHz bzw. bei Y=4,32·10$^{-1}$ $u_{SK}$/V, X=2,517 f/MHz.

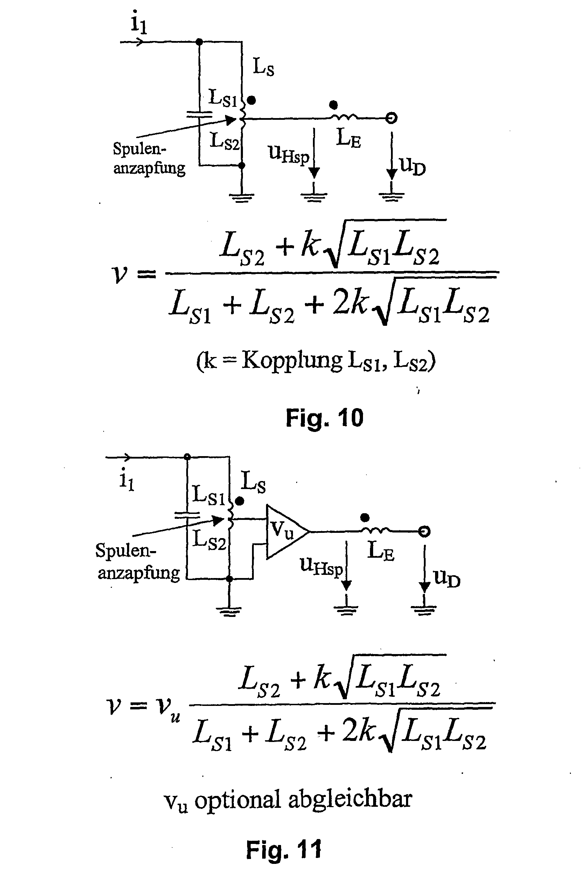

In den Figuren 10 und 11 sind zwei weitere Beispiele eines induktiven Näherungsschalters zur Gewinnung der Hilfs- bzw. Differenzspannung $u_{Hsp}$ bzw. $u_D$ gezeigt. In beiden Beispielen in den Figuren 10 und 11 erfolgt die Gewinnung der Hilfs- bzw. Differenzspannung $u_{Hsp}$ bzw. $u_D$ nicht mittels eines kapazitiven Spannungsteilers, sondern die Hilfsspannungserzeugung $u_{Hsp}$ wird durch eine entsprechend positionierte Anzapfung durch einen Anzapfpunkt an der Sendespule $L_S$ gewonnen, welcher Anzapfpunkt die Sendespule $L_S$ in die Teilinduktivitäten $L_{S1}$ und $L_{S2}$ aufteilt. Der Anzapfpunkt an der Sendespule $L_S$ ist in weiten Bereichen frei wählbar. Ein besonderer Vorteil dieser Variante liegt darin, dass bei Verwendung von Printspulen hiermit eine besonders hohe Reproduzierbarkeit des Teilerverhältnisses v realisiert werden kann, welches sich berechnet zu:

$$v = \frac{L_{S2} + k\sqrt{L_{S1}L_{S2}}}{L_{S1} + L_{S2} + 2k\sqrt{L_{S1}L_{S2}}} \qquad (k = \text{Kopplung } L_{S1}, L_{S2})$$

Figur 11 zeigt eine Ausgestaltung der beispielhaften Schaltung in Anlehnung an Figur 10, wobei hier die aus der Spulenanzapfung gewonnene Spannung - entsprechend der in Figur 3 im Punkt M gewonnenen Spannung - in einem Verstärker A bzw. Impedanzwandler verstärkt wird. Damit wird eine Abgleichbarkeit des Teilerverhältnisses v der Teilinduktivitäten $L_{S1}$ und $L_{S2}$ der Sendespule $L_S$ ermöglicht, indem der Sendespule $L_S$ optional zusätzlich der Verstärker A bzw. Impedanzwandler nachgeschaltet wird, welcher eine abgleichbare Spannungsverstärkung aufweist. Daraus resultiert ein effektives Teilerverhältnis $v_{eff}$. Das Teilerverhältnis v berechnet sich wie nachstehend angegeben, wobei $v_u$ optional abgleichbar ist:

$$v = v_u \frac{L_{S2} + k\sqrt{L_{S1}L_{S2}}}{L_{S1} + L_{S2} + 2k\sqrt{L_{S1}L_{S2}}}$$

In den Schaltungen der Figuren 1, 2, 3 oder 7 mit einem komplexen oder kapazitiven Spannungsteiler zur Gewinnung des Hilfsspannungssignals $u_{Hsp}$ als Teilspannung aus der Schwingkreisspannung $u_{SK}$ des Schwingkreises $L_S$, C kann jeweils gleichermaßen zwischen dem Mittenpunkt M, gelegen zwischen den beiden in Reihe geschalteten komplexen Widerständen $Z_1$ und $Z_2$ bzw. den beiden in Reihe geschalteten Kondensatoren $C_1$ und $C_2$, und der Empfangsspule $L_E$ ein Verstärker, wie derjenige Verstärker A in Figur 11 dargestellt, angeordnet sein. Auf diese Weise ermöglicht der Einsatz eines derartigen Verstärkers eine abgleichbare Spannungsverstärkung. Das in der Figur 3 im Abbild des Impedanzwandlers IW angegebene feste Verhältnis zwischen Eingangs- und Ausgangsspannung - dort angegeben zu "1" - muss nicht fest sein, sondern kann, wie aufgezeigt, durch eine veränderbare oder abgleichbare Spannungsverstärkung zwischen Ein- und Ausgangsspannung aufgrund in weiten Bereichen freier Wahl des Anzapfpunktes an der Sendespule $L_S$ bzw. in weiten Bereichen freier Wahl des Mittenpunktes M (Figuren 1,2,3, 7) innerhalb des Netzwerks T ersetzt oder ergänzt werden.

Gewerbliche Anwendbarkeit:

Die Erfindung ist insbesondere in induktiven Näherungsschaltern zur erheblichen Verbesserung der Temperaturunabhängigkeit und der Relativänderung bei der Annäherung eines Targets oder Auslösers, mehr oder weniger gut leitend, gewerblich anwendbar.

Liste der Bezugszeichen:

$L_S$      Sendespule

$L_E$      Empfangsspule

C      Schwingkreiskapazität

| | |
|---|---|
| $Z_1, Z_2$ | komplexe Widerstände eines Spannungsteilers |
| $C_1, C_2$ | Kondensatoren eines kapazitiven Spannungsteilers |
| $R_1, R_2$ | ohmsche Widerstände eines Spannungsteilers |
| $u_{Hsp}$ | Hilfsspannung bzw. Hilfsspannungssignal |
| $u_D$ | Differenzspannung bzw. Differenzspannungssignal |
| G | Masse |
| IW | Impedanzwandler |
| V | Verstärker |
| m | Verstärkungsfaktor des Verstärkers |
| S | Transkonduktanzverstärker |
| $D_G$ | Diodengleichrichter |
| $S_K$ | Schaltschwellendiskriminator |
| $u_{Schalt}$ | Spannungsschaltsignal der Auswerteschaltung |
| $u_{SK}$ | Schwingkreisspannung |
| $L_S, C$ | Schwingkreis |
| T | Netzwerke |
| $i_s$ | Speisestrom für den Schwingkreis |
| PS | Phasenschieber |
| $p_i$ | Phaseninformation aus dem Speisestrom $i_s$ |
| MP | Multiplizierer |
| IS | Stromquelle |

**Patentansprüche**

**1.** Induktiver Näherungsschalter mit einem Netzwerk,
wobei das Netzwerk einen stromgespeisten Schwingkreis ($L_S$, C), bestehend aus wenigstens einer Schwingkreis-Sendespule ($L_S$) und einer Kapazität (C), sowie wenigstens eine Empfangsspule ($L_E$) aufweist, und
mit Mitteln, durch welche die Schwingkreis-Sendespule ($L_S$) veranlasst werden kann, ein magnetisches Wechselfeld zu erzeugen, welches in der wenigstens einen Empfangsspule ($L_E$) eine Gegeninduktionsspannung zu induzieren imstande ist,
wobei der Schwingkreis durch einen in das Wechselfeld eindringenden oder sich entfernenden metallischen Auslöser in seinem Schwingungszustand beeinflussbar ist, und mit einer Auswerteschaltung zur Gewinnung eines Schaltsignals ($u_{schalt}$) aus der Änderung des Schwingungszustands des Schwingkreises,
wobei zum Generieren des Schaltsignals ($u_{schlit}$) die Änderung der komplexen Kopplung zwischen den wenigstens zwei Spulen, Sendespule ($L_S$) und Empfangsspule ($L_E$), unter Zuhilfenahme eines Hilfsspannungssignals ($u_{Hsp}$) bei Anwesenheit oder Abwesenheit des Auslösers auswertbar ist,
**dadurch gekennzeichnet,**

**dass** das Hilfsspannungssignal ($u_{Hsp}$) als Teilspannung aus der Schwingkreisspannung ($u_{SK}$) des Schwingkreises ($L_S$, C) des Netzwerkes in einem vorgebbaren Verhältnis (v) gewonnen wird, indem dem Schwingkreis ($L_s$, C) ein komplexer Spannungsteiler aus einer Reihenschaltung aus zwei Kondensatoren ($C_1$, $C_2$) parallel geschaltet ist und das Hilfsspannungssignal ($u_{Hsp}$) über dem zweiten ($C_2$) der beiden Kondensatoren abfällt, wobei die Kapazität (C) des Schwingkreises ganz oder teilweise von den Kondensatoren ($C_1$, $C_2$) gebildet ist und wobei der zweite Kondensator ($C_2$) so mit der Empfangsspule ($L_E$) in Serie geschaltet ist, dass am Ausgang der Empfangsspule ($L_E$) gegen Masse (G) oder gegen ein Potential eine Differenzspannung ($u_D$) erhalten wird, welche gegenüber der induzierten Gegeninduktionsspannung betragsmäßig um das Hilfsspannungssignal ($u_{Hsp}$) vermindert ist, wobei aus der Differenzspannung ($u_D$) das Schaltsignal ($u_{schalt}$) generiert wird.

**2.** Induktiver Näherungsschalter nach Anspruch 1,
**dadurch gekennzeichnet,**
**dass** die Differenzspannung ($u_D$) der Auswerteschaltung ($S_K$) zum Erhalt des Schaltsignals ($u_{schalt}$) zugeführt ist.

**3.** Induktiver Näherungsschalter nach Anspruch 1,
**dadurch gekennzeichnet,**
**dass** die Differenzspannung ($u_D$) einem Transkonduktanzverstärker (TK) zugeführt ist zur Gewinnung und Rückführung des den Schwingkreis ($L_s$, C) des Oszillators speisenden, der Differenzspannung ($u_D$) proportionalen Stromes ($i_1$), und die Schwingkreisspannung ($u_{SK}$) der Auswerteschaltung ($D_G$, $S_K$) zum Erhalt des Schaltsignals ($u_{Schalt}$) zugeführt ist.

**4.** Induktiver Näherungsschalter nach Anspruch 3,
**dadurch gekennzeichnet,**
**dass** der Transkonduktanzverstärker (TK) ein solcher mit wählbarer Steilheit (s) ist.

**5.** Induktiver Näherungsschalter nach einem der Ansprüche 1 bis 4,
**dadurch gekennzeichnet,**
**dass** mittels des vorgebbaren Verhältnisses (v) zwischen Hilfsspannungssignal ($u_{Hsp}$) und Schwingkreisspannung ($u_{SK}$) die Differenzspannung ($u_D$) so wählbar ist, dass die Differenzspannung ($u_D$) entweder bei Resonanz des Schwingkreises ($L_S$, C) bzw. in der Resonanzamplitude der Schwingkreisspannung ($u_{SK}$) temperaturunabhängig wird oder für eine Amplitude der Schwingkreisspannung ($u_{SK}$) temperaturunabhängig ist, welche symmetrisch zur Resonanzfrequenz des Schwingkreises ($L_S$, C) auf den Resonanzflanken liegt.

**6.** Induktiver Näherungsschalter nach einem der Ansprüche 1 bis 5,
**dadurch gekennzeichnet,**
**dass** an den Mittelpunkt (M) des Spannungsteilers ($C_1$, $C_2$) das eine Ende der Empfangsspule ($L_E$) gelegt ist, an deren anderen Ende die Differenzspannung ($u_D$) erhalten wird.

**7.** Induktiver Näherungsschalter nach einem der Ansprüche 1 bis 6,
**dadurch gekennzeichnet,**
**dass** die Kapazität (C) des Schwingkreises teilweise von der Eigenkapazität der Sendespule ($L_S$) gebildet ist.

**8.** Induktiver Näherungsschalter nach einem der Ansprüche 1 bis 7,
**dadurch gekennzeichnet,**
**dass** das Hilfsspannungssignal ($u_{Hsp}$) gleichzeitig an die zwei Signaleingänge eines Impedanzwandlers (IW) gelegt ist, wobei das eine Ende der Empfangsspule ($L_E$) an den Ausgang des Impedanzwandlers (IW) gelegt ist und am Ausgang der Empfangsspule ($L_E$), gegen Masse (G) oder gegen ein Potential, die Differenzspannung ($u_D$) erhalten wird.

**9.** Induktiver Näherungsschalter nach einem der Ansprüche 1 bis 8,
**dadurch gekennzeichnet,**
**dass** wenigstens einer der beiden komplexen Widerstände ($Z_1$,$Z_2$) des komplexen Spannungsteilers einstellbar ist, so dass die Schwingkreisspannung ($u_{SK}$) des Schwingkreises ($L_S$, C) in einem einstellbaren Verhältnis (v) geteilt wird und damit eine einstellbare Differenzspannung ($u_D$) am Ausgang der Empfangsspule ($L_E$) erhalten wird.

**10.** Induktiver Näherungsschalter nach einem der Ansprüche 1 bis 9,
**dadurch gekennzeichnet,**
**dass** die wenigstens eine Sendespule ($L_S$) und die wenigstens eine Empfangsspule ($L_E$) ein Planarspulensystem bilden.

**11.** Induktiver Näherungsschalter nach einem der Ansprüche 1 bis 10,
**dadurch gekennzeichnet,**
**dass** die wenigstens eine Sendespule ($L_s$) und die wenigstens eine Empfangsspule ($L_E$) als Leiterplattenspulen ausgestaltet sind.

**12.** Induktiver Näherungsschalter nach einem der Ansprüche 1 bis 11,
**dadurch gekennzeichnet,**
**dass** die Schwingkreisspannung ($u_{SK}$) gleichgerichtet und einem Schwellwertdiskriminator ($S_K$) zum Erhalt des Schaltsignals ($u_{Schalt}$) zugeführt wird.

**13.** Induktiver Näherungsschalter nach Anspruch 1,
dadurch **gekenntzeichnet**,
dass mittels einer Stromquelle (IS) dem Schwingkreis ein Speisestrom ($i_1$) eingeprägt und die Differenzspannung ($u_D$) einem Verstärker (V2) zugeführt ist, an dessen Ausgang der eine Eingang eines Multiplizierers (MP) angeschlossen ist, und an dessen anderen Eingang die Phaseninformation ($p_i$) des Speisestromes ($i_1$), vorzugsweise mittels eines Phasenschiebers beeinflusst, gelegt ist und der Ausgang des Multiplizierers (MP) der Auswerteschaltung ($D_G$, $S_K$) zum Erhalt des Schaltsignals ($u_{Schalt}$) zugeführt ist.

**14.** Verfahren zum Betreiben eines induktiven Näherungsschalters mit einem Schwingkreis ($L_S$, C), bestehend aus wenigstens einer Schwingkreis-Sendespule ($L_S$) und einer Kapazität (C),
wobei die Schwingkreis-Sendespule ($L_S$) ein magnetisches Wechselfeld erzeugt, welches in wenigstens einer Empfangsspule ($L_E$) eine Gegeninduktionsspannung induziert, und
der Schwingkreis durch einen in das Wechselfeld eindringenden oder sich entfernenden metallischen Auslöser in seinem Schwingungszustand beeinflusst wird,
mit einer Auswerteschaltung zur Gewinnung eines Schaltsignals ($u_{Schalt}$) aus der Änderung des Schwingungszustandes des Schwingkreises,
wobei die Änderung der komplexen Kopplung zwischen den wenigstens zwei Spulen, Sendespule ($L_S$) und Empfangsspule ($L_E$), unter Zuhilfenahme eines Hilfsspannungssignals ($u_{Hsp}$) bei Anwesenheit oder Abwesenheit des Auslösers zur Generierung des Schaltsignals ($u_{Schalt}$) ausgewertet wird, **dadurch gekennzeichnet,**
**dass** das Hilfsspannungssignal ($u_{Hsp}$) als Teilspannung aus der Schwingkreisspannung ($u_{SK}$) des Schwingkreises ($L_S$, C) in einem vorgebbaren Verhältnis (v) gewonnen wird, indem dem Schwingkreis ($L_S$, C) ein komplexer Spannungsteiler aus zwei Kondensatoren ($C_1$, $C_2$) parallel geschaltet ist, wobei das Hilfsspannungssignal ($u_{Hsp}$) über dem zweiten ($C_2$) der beiden Kondensatoren abfällt, wobei die Kapazität (C) des Schwingkreises ganz oder teilweise von den Kondensatoren ($C_1$, $C_2$) gebildet ist und
wobei der zweite Kondensator ($C_2$) so mit der in der Empfangsspule ($L_E$) induzierten Gegeninduktionsspannung in Serie geschaltet wird, dass am Ausgang der Empfangsspule ($L_E$), gegen Masse (G) oder gegen ein Potential, eine Differenzspannung ($u_D$) erhalten wird, welche gegenüber der induzierten Gegeninduktionsspannung betragsmäßig um das Hilfsspannungssignal ($u_{HSp}$) vermindert ist, und
wobei aus der Differenzspannung ($u_D$) das Schaltsignal ($u_{Schalt}$) generiert wird.

**15.** Verfahren nach Anspruch 14,
**dadurch gekennzeichnet,**
**dass** die Differenzspannung ($u_D$) der Auswerteschaltung ($D_G$, $S_K$) zum Erhalt des Schaltsignals ($u_{Schalt}$) zugeführt wird.

**16.** Verfahren zum Betreiben eines induktiven Näherungsschalters nach Anspruch 14,
**dadurch gekennzeichnet,**
**dass** die Differenzspannung ($u_D$) einem Transkonduktanzverstärker (TK) zugeführt wird, dessen der Differenzspannung ($u_D$) proportionaler Strom ($i_1$) in den Schwingkreis ($L_S$, C) des Oszillators rückgespeist wird, und die Schwingkreisspannung ($u_{SK}$) der Auswerteschaltung ($D_G$, $S_K$) zum Erhalt des Schaltsignals ($u_{Schalt}$) zugeführt, wird.

**17.** Verfahren nach einem der Ansprüche 14 bis 16,
**dadurch gekennzeichnet,**
**dass** die Schwingkreisspannung ($u_{SK}$) des Schwingkreises ($L_S$, C) in einem einstellbaren Verhältnis (v) geteilt wird und dadurch eine einstellbare Differenzspannung ($u_D$) am Ausgang der Empfangsspule ($L_E$) erhalten wird.

**18.** Verfahren nach einem der Ansprüche 14 bis 16,
**dadurch gekennzeichnet,**
**dass** mittels des vorgebbaren Verhältnisses (v) zwischen Hilfsspannungssignal ($u_{Hsp}$) und Schwingkreisspannung ($u_{SK}$) die Differenzspannung ($u_D$) so gewählt wird, dass die Differenzspannung ($u_D$) entweder bei Resonanz des Schwingkreises ($L_S$, C) bzw. in der Resonanzamplitude der Schwingkreisspannung ($u_{SK}$) temperaturunabhängig wird oder für eine Amplitude der Schwingkreisspannung ($u_{SK}$) temperaturunabhängig wird, welche symmetrisch zur Resonanzfrequenz des Schwingkreises ($L_S$, C) auf den Resonanzflanken liegt.

**Claims**

**1.** Inductive proximity switch with a network,
wherein the network has a current-fed resonant circuit ($L_S$, C) comprising at least one resonant circuit transmitting coil ($L_S$) and a capacitance (C) and at least one receiving coil ($L_E$), and
with means, through which the resonant circuit transmitting coil ($L_S$) can be triggered to generate an alternating magnetic field which can induce a mutual induction voltage in the at least one receiving coil ($L_E$),
wherein the resonant circuit can be influenced in its oscillation state by a metallic trigger element entering or moving away from the alternating field, and with an evaluating circuit for obtaining a switching signal ($u_{Schalt}$) from the change of the oscillation state of the resonant circuit,
wherein in order to generate the switching signal ($u_{Schalt}$) the change of the complex coupling between the at least two coils, namely transmitting coil ($L_S$) and receiving coil ($L_E$), can be evaluated with the aid of an auxiliary voltage signal ($u_{Hsp}$) in the presence or absence of the trigger element,
**characterised in that**
the auxiliary voltage signal ($u_{Hsp}$) is obtained as a partial voltage from the resonant circuit voltage ($u_{SK}$) of the resonant circuit ($L_S$, C) of the network in a presettable ratio (v) **in that** a complex voltage divider comprising a series connection of two capacitors ($C_1$, $C_2$) is connected in parallel with the resonant circuit ($L_S$, C) and the auxiliary voltage signal ($u_{Hsp}$) reduces over the second ($C_2$) of the two capacitors,
wherein the capacitance (C) of the resonant circuit is formed wholly or partially by the capacitors ($C_1$, $C_2$) and wherein the second capacitor ($C_2$) is connected in series with the receiving coil ($L_E$) in such a way that a differential voltage ($u_D$) is obtained in relation to ground (G) or a potential at the output of the receiving coil ($L_E$), said differential voltage ($u_D$) being reduced in its amount in relation to the induced mutual induction voltage by the auxiliary voltage signal ($u_{Hsp}$), wherein the switching signal ($u_{Schalt}$) is generated from the differential voltage ($u_D$).

**2.** Inductive proximity switch according to claim 1,
**characterised in that**
the differential voltage ($u_D$) is supplied to the evaluating circuit ($S_K$) for obtaining the switching signal ($u_{Schalt}$).

**3.** Inductive proximity switch according to claim 1,
**characterised in that**
the differential voltage ($u_D$) is supplied to a trans-conductance amplifier (TK) for obtaining and returning the current ($i_1$) proportional to the differential voltage ($u_D$) supplying the resonant circuit ($L_S$, C) of the oscillator, and the resonant circuit voltage ($U_{SK}$) is supplied to the evaluating circuit ($D_G$, $S_K$) for obtaining the switching signal ($u_{Schalt}$).

**4.** Inductive proximity switch according to claim 3,
**characterised in that**
the trans-conductance amplifier (TK) has a selectable slope (s).

**5.** Inductive proximity switch according to one of the claims 1 to 4,
**characterised in that**
the differential voltage ($u_D$) can be selected by means of the presettable ratio (v) between the auxiliary voltage signal ($u_{Hsp}$) and the resonant circuit voltage ($U_{SK}$) in such a way that the differential voltage ($u_D$) becomes temperature-independent either at resonance of the resonant circuit ($L_S$, C) or in the resonance amplitude of the resonant circuit voltage ($u_{SK}$) respectively, or is temperature-independent for an amplitude of the resonant circuit voltage ($u_{SK}$) which lies symmetrically to the resonance frequency of the resonant circuit ($L_S$, C) on the resonance slopes.

**6.** Inductive proximity switch according to one of the claims 1 to 5,
**characterised in that**
one end of the receiving coil ($L_E$) is applied to the center point (M) of the voltage divider ($C_1$, $C_2$), at the other end of which the differential voltage ($u_D$) is obtained.

7. Inductive proximity switch according to one of the claims 1 to 6,
   **characterised in that**
   the capacitance (C) of the resonant circuit is partially formed by the self- capacitance of the transmitting coil ($L_S$).

8. Inductive proximity switch according to one of the claims 1 to 7,
   **characterised in that**
   the auxiliary voltage signal ($u_{Hsp}$) is simultaneously applied to the two signal inputs of an impedance converter (IW), wherein one end of the receiving coil ($L_E$) is applied to the output of the impedance converter (IW) and the differential voltage ($u_D$) is obtained at the output of the receiving coil ($L_E$), in relation to ground (G) or a potential.

9. Inductive proximity switch according to one of the claims 1 to 8,
   **characterised in that**
   at least one of the two complex resistors ($Z_1$, $Z_2$) of the complex voltage divider can be adjusted so that the resonant circuit voltage ($u_{SK}$) of the resonant circuit ($L_S$, C) is divided in an adjustable ratio (v) and an adjustable differential voltage ($u_D$) is thus obtained at the output of the receiving coil ($L_E$).

10. Inductive proximity switch according to one of the claims 1 to 9,
    **characterised in that**
    the at least one transmitting coil ($L_S$) and the at least one receiving coil ($L_E$) form a planar coil system.

11. Inductive proximity switch according to one of the claims 1 to 10,
    **characterised in that**
    the at least one transmitting coil ($L_S$) and the at least one receiving coil ($L_E$) are in the form of circuit board coils.

12. Inductive proximity switch according to one of the claims 1 to 11,
    **characterised in that**
    the resonant circuit voltage ($u_{SK}$) is rectified and supplied to a threshold discriminator ($S_K$) for obtaining the switching signal ($u_{Schalt}$).

13. Inductive proximity switch according to claim 1,
    **characterised in that**
    a supply current ($i_1$) is impressed on the resonant circuit by means of a power source (IS) and the differential voltage ($u_D$) is supplied to an amplifier (V2), to the output of which an input of a multiplier (MP) is connected, and to the other input of which the phase information ($p_i$) of the supply current ($i_1$) is applied, preferably influenced by means of a phase shifter, and the output of the multiplier (MP) is supplied to the evaluating circuit ($D_G$, $S_K$) for obtaining the switching signal ($U_{Schalt}$).

14. Method for operating an inductive proximity switch,
    with a resonant circuit ($L_S$, C) comprising at least one resonant circuit transmitting coil ($L_S$) and a capacitance (C), wherein the resonant circuit transmitting coil ($L_S$) generates an alternating magnetic field which induces a mutual induction voltage in at least one receiving coil ($L_E$), and
    the resonant circuit is influenced in its oscillation state by a metallic trigger element entering or moving away from the alternating field-,
    with an evaluating circuit for obtaining a switching signal ($u_{Schalt}$) from the change of the oscillation state of the resonant circuit,
    wherein the change of the complex coupling between the at least two coils, namely transmitting coil ($L_S$) and receiving coil ($L_E$), is evaluated with the aid of an auxiliary voltage signal ($u_{Hsp}$) in the presence or absence of the trigger element for generating the switch signal ($u_{Schalt}$),
    **characterised in that**
    the auxiliary voltage signal ($u_{Hsp}$) is obtained as a partial voltage from the resonant circuit voltage ($u_{SK}$) of the resonant circuit ($L_S$, C) in a presettable ratio (v), by
    a complex voltage divider comprising two capacitors ($C_1$, $C_2$) is connected in parallel with the resonant circuit ($L_S$, C), wherein the auxiliary voltage signal ($u_{HSP}$) falls over the second ($C_2$) of the two capacitors,
    the capacitance (C) of the resonant circuit is formed wholly or partially by the capacitors ($C_1$, $C_2$), and
    the second capacitor ($C_2$) is connected in series with the mutual induction voltage induced in the receiving coil ($L_E$) in such a way that a differential voltage ($u_D$), in relation to ground (G) or a potential, is obtained at the output of the receiving coil ($L_E$), the amount of said differential voltage ($u_D$) being reduced in comparison with the induced mutual induction voltage by the auxiliary voltage signal ($u_{Hsp}$), and
the switching signal ($u_{Schalt}$) is generated from the differential voltage ($u_D$).

15. Method according to claim 14,
**characterised in that**
the differential voltage ($u_D$) is supplied to the evaluating circuit ($D_G$, $S_K$) for obtaining the switching signal ($u_{Schalt}$).

16. Method for operating an inductive proximity switch according to claim 14,
**characterised in that**
the differential voltage ($u_D$) is supplied to a trans-conductance amplifier (TK), of which the current ($i_1$) proportional to the differential voltage ($u_D$) is fed back into the resonant circuit ($L_S$, C) of the oscillator, and the resonant circuit voltage ($u_{SK}$) is supplied to the evaluating circuit ($D_G$, $S_K$) for obtaining the switching signal ($U_{Schalt}$).

17. Method according to one of the claims 14 to 16,
**characterised in that**
the resonant circuit voltage ($u_{SK}$) of the resonant circuit ($L_S$, C) is divided in an adjustable ratio (v) and an adjustable differential voltage ($u_D$) is thereby obtained at the output of the receiving coil ($L_E$).

18. Method according to one of the claims 14 to 16,
**characterised in that**
the differential voltage ($u_D$) is selected by means of the presettable ratio (v) between the auxiliary voltage signal ($u_{Hsp}$) and the resonant circuit voltage ($u_{SK}$) in such a way that the differential voltage ($u_D$) becomes temperature-independent either at resonance of the resonant circuit ($L_S$, C) or in the resonance amplitude of the resonant circuit voltage ($u_{SK}$) respectively, or becomes temperature-independent for an amplitude of the resonant circuit voltage ($u_{SK}$) which lies symmetrically to the resonance frequency of the resonant circuit ($L_S$, C) on the resonance slopes.

**Revendications**

1. Détecteur de proximité inductif avec un réseau
dans lequel le réseau présente un circuit oscillant ($L_S$, C) alimenté électriquement, constitué d'au moins une bobine émettrice de circuit oscillant ($L_S$) et d'une capacité (C), ainsi qu'au moins une bobine réceptrice ($L_E$), et
avec des moyens par lesquels la bobine émettrice ($L_S$) de circuit oscillant peut être amenée à produire un champ magnétique alternatif qui est capable d'induire une tension de contre-induction dans la bobine réceptrice (LE) au nombre d'au moins un,
dans lequel le circuit oscillant peut être influencé dans son état d'oscillation par un déclencheur métallique pénétrant dans le champ alternatif ou s'en éloignant, et avec un circuit d'analyse pour récupérer un signal de commutation ($u_{Schalt}$) à partir de la variation de l'état d'oscillation du circuit oscillant,
dans lequel, pour générer le signal de commutation ($u_{Schalt}$), la modification du couplage complexe entre les bobines au nombre d'au moins deux, bobine émettrice ($L_S$) et bobine réceptrice (LE), peut être exploitée en s'aidant d'un signal de tension auxiliaire ($u_{Hsp}$) en présence ou en l'absence du déclencheur,
**caractérisé en ce que**
le signal de tension auxiliaire ($u_{Hsp}$) est obtenu sous forme de sous-tension à partir de la tension de circuit oscillant ($u_{SK}$) du circuit oscillant ($L_S$, C) du réseau selon un rapport (v) prédéterminé, un diviseur complexe de tension constitué d'un montage série de deux condensateurs ($C_1$, $C_2$) étant monté en parallèle sur le circuit oscillant ($L_S$, C) et le signal de tension auxiliaire ($u_{Hsp}$) diminuant sur le deuxième ($C_2$) des deux condensateurs,
dans lequel la capacité (C) du circuit oscillant est formée entièrement ou partiellement par les condensateurs ($C_1$, $C_2$), et
dans lequel le deuxième condensateur ($C_2$) est monté en série avec la bobine réceptrice ($L_E$) de telle manière qu'à la sortie de la bobine réceptrice (LE), on obtient par rapport à la terre (G) ou à un potentiel une différence de tension ($u_D$) qui, par rapport à la tension de contre-induction induite, est réduite en valeur du signal de tension auxiliaire ($u_{Hsp}$), le signal de commutation ($u_{Schalt}$) étant généré à partir de la différence de tension ($u_D$).

2. Détecteur de proximité inductif selon la revendication 1,
**caractérisé en ce que**
la différence de tension ($u_D$) est fournie au circuit d'analyse ($S_K$) pour obtenir le signal de commutation ($u_{Schalt}$).

**EP 2 309 646 B1**

**3.** Détecteur de proximité inductif selon la revendication 1,
**caractérisé en ce que**
la différence de tension ($u_D$) est fournie à un amplificateur de transconductance (TK) pour obtenir et réintroduire le courant ($i_1$) proportionnel à la différence de tension ($u_D$) alimentant le circuit oscillant ($L_S$, C) de l'oscillateur, et la tension de circuit oscillant ($u_{SK}$) est introduite dans le circuit d'analyse ($D_G$, $S_K$) pour obtenir le signal de commutation ($u_{Schalt}$).

**4.** Détecteur de proximité inductif selon la revendication 3,
**caractérisé en ce que**
l'amplificateur de transconductance (TK) est du type à pente sélectionnable (s).

**5.** Détecteur de proximité inductif selon l'une des revendications 1 à 4,
**caractérisé en ce que**
au moyen du rapport prédéterminable (v) entre le signal de tension auxiliaire ($u_{Hsp}$) et la tension de circuit oscillant ($u_{SK}$), la différence de tension ($u_D$) peut être choisie de telle manière que la différence de tension ($u_D$) soit devient indépendante de la température à la résonance du circuit oscillant ($L_S$, C) ou à l'amplitude de résonance de la tension de circuit oscillant ($u_{SK}$), soit est indépendante de la température pour une amplitude de la tension de circuit oscillant ($u_{SK}$) qui est située sur les flancs de la résonance de manière symétrique à la fréquence de résonance du circuit oscillant ($L_S$, C).

**6.** Détecteur de proximité inductif selon l'une des revendications 1 à 5,
**caractérisé en ce qu'**
au milieu (M) du diviseur de tension ($C_1$, $C_2$) est appliquée la première extrémité de la bobine réceptrice (LE), à l'autre extrémité de laquelle on obtient la différence de tension ($u_D$).

**7.** Détecteur de proximité inductif selon l'une des revendications 1 à 6,
**caractérisé en ce que**
la capacité (C) du circuit oscillant est formée partiellement par la capacité propre de la bobine émettrice ($L_S$).

**8.** Détecteur de proximité inductif selon l'une des revendications 1 à 7,
**caractérisé en ce que**
le signal de tension auxiliaire ($u_{Hsp}$) est appliqué simultanément aux entrées de signaux d'un convertisseur d'impédance (IW), la première extrémité de la bobine réceptrice (LE) étant raccordée à la sortie du convertisseur d'impédance (IW) et la différence de tension ($u_D$) étant obtenue sur la sortie de la bobine réceptrice (LE), par rapport à la masse (G) ou à un potentiel.

**9.** Détecteur de proximité inductif selon l'une des revendications 1 à 8,
**caractérisé en ce qu'**
au moins l'une des deux résistances complexes ($Z_1$, $Z_2$) du diviseur de tension complexe est réglable, de sorte que la tension de circuit oscillant ($u_{SK}$) du circuit oscillant ($L_S$, C) est divisée selon un rapport réglable (v) et, ainsi, on obtient une différence de tension ($u_D$) réglable à la sortie de la bobine réceptrice (LE).

**10.** Détecteur de proximité inductif selon l'une des revendications 1 à 9,
**caractérisé en ce que**
la bobine émettrice ($L_S$) au nombre d'au moins un et la bobine réceptrice (LE) au nombre d'au moins un forment un système de bobines plan.

**11.** Détecteur de proximité inductif selon l'une des revendications 1 à 10,
**caractérisé en ce que**
la bobine émettrice ($L_S$) au nombre d'au moins un et la bobine réceptrice (LE) au nombre d'au moins un sont conformées en bobine de circuit imprimé.

**12.** Détecteur de proximité inductif selon l'une des revendications 1 à 11,
**caractérisé en ce que**
la tension de circuit oscillant ($u_{SK}$) est redressée et introduite dans un discriminateur de seuil ($S_K$) pour obtenir le signal de commutation ($u_{Schalt}$).

**13.** Détecteur de proximité inductif selon la revendication 1,

**caractérisé en ce qu'**

au moyen d'une source de courant (IS), un courant d'alimentation ($i_1$) est appliqué au circuit oscillant et la différence de tension ($u_D$) est introduite dans un amplificateur (V2) à la sortie duquel est raccordée la première entrée d'un multiplicateur (MP) et à l'autre entrée duquel l'information de phase ($p_1$) du courant d'alimentation ($i_1$) est appliquée, de préférence influencée au moyen d'un décaleur de phase, et la sortie du multiplicateur (MP) est envoyée au circuit d'analyse ($D_G$, $S_K$) pour obtenir le signal de commutation ($u_{Schalt}$).

**14.** Procédé de fonctionnement d'un détecteur de proximité inductif,

avec un circuit oscillant ($L_S$, C) constitué d'au moins une bobine émettrice de circuit oscillant ($L_S$) et d'une capacité (C), dans lequel la bobine émettrice ($L_S$) de circuit oscillant produit un champ magnétique alternatif qui est capable d'induire une tension de contre-induction dans au moins une bobine réceptrice (LE), et

le circuit oscillant peut être influencé dans son état d'oscillation par un déclencheur métallique pénétrant dans le champ alternatif ou s'en éloignant, avec un circuit d'analyse pour récupérer un signal de commutation ($u_{Schalt}$) à partir de la variation de l'état d'oscillation du circuit oscillant,

dans lequel la modification du couplage complexe entre les bobines au nombre d'au moins deux, bobine émettrice ($L_S$) et bobine réceptrice ($L_E$), est exploitée en s'aidant d'un signal de tension auxiliaire ($u_{Hsp}$) en présence ou en l'absence du déclencheur pour générer le signal de commutation ($u_{Schalt}$),

**caractérisé en ce que**

le signal de tension auxiliaire ($u_{Hsp}$) est obtenu sous forme de sous-tension à partir de la tension de circuit oscillant ($u_{SK}$) du circuit oscillant ($L_S$, C) selon un rapport (v) prédéterminé,

un diviseur complexe de tension constitué de deux condensateurs ($C_1$, $C_2$) étant monté en parallèle sur le circuit oscillant ($L_S$, C) et le signal de tension auxiliaire ($u_{Hsp}$) diminuant sur le deuxième ($C_2$) des deux condensateurs, dans lequel la capacité (C) du circuit oscillant est formée entièrement ou partiellement par les condensateurs ($C_1$, $C_2$), et

dans lequel le deuxième condensateur ($C_2$) est monté en série avec la tension de contre-induction induite dans la bobine réceptrice (LE) de telle manière qu'à la sortie de la bobine réceptrice ($L_E$), on obtient par rapport à la terre (G) ou à un potentiel une différence de tension ($u_D$) qui, par rapport à la tension de contre-induction induite, est réduite en valeur du signal de tension auxiliaire ($u_{Hsp}$), et

dans lequel le signal de commutation ($u_{Schalt}$) est généré à partir de la différence de tension ($u_D$).

**15.** Procédé selon la revendication 14,

**caractérisé en ce que**

la différence de tension ($u_D$) est fournie au circuit d'analyse ($D_G$, $S_K$) pour obtenir le signal de commutation ($U_{Schalt}$)

**16.** Procédé de fonctionnement d'un détecteur de proximité inductif selon la revendication 14,

**caractérisé en ce que**

la différence de tension ($u_D$) est fournie à un amplificateur de transconductance (TK), dont le courant ($i_1$) proportionnel à la différence de tension ($u_D$) est réintroduite dans le circuit oscillant ($L_S$, C) de l'oscillateur, et la tension de circuit oscillant ($u_{SK}$) est introduite dans le circuit d'analyse ($D_G$, $S_K$) pour obtenir le signal de commutation ($U_{Schalt}$).

**17.** Procédé selon l'une des revendications 14 à 16,

**caractérisé en ce que**

la tension de circuit oscillant ($u_{SK}$) du circuit oscillant ($L_S$, C) est divisée selon un rapport (v) réglable et, ainsi, on obtient une différence de tension ($u_D$) réglable à la sortie de la bobine réceptrice ($L_E$).

**18.** Procédé selon l'une des revendications 14 à 16,

**caractérisé en ce que**

au moyen du rapport prédéterminable (v) entre le signal de tension auxiliaire ($u_{Hsp}$) et la tension de circuit oscillant ($u_{SK}$), la différence de tension ($u_D$) peut être choisie de telle manière que la différence de tension ($u_D$) soit devient indépendante de la température à la résonance du circuit oscillant ($L_S$, C) ou à l'amplitude de résonance de la tension de circuit oscillant ($u_{SK}$), soit est indépendante de la température pour une amplitude de la tension de circuit oscillant ($u_{SK}$) qui est située sur les flancs de la résonance de manière symétrique à la fréquence de résonance du circuit oscillant ($L_S$, C).

$$v = Z_2/(Z_1+Z_2)$$

Fig. 1

$$v = C_1/(C_1+C_2)$$

Fig. 2

$$v = R_2/(R_1+R_2)$$

Fig. 3

$M > L$

Fig. 4

EP 2 309 646 B1

$i_1 = Su_D$

Fig. 5

Fig. 6

EP 2 309 646 B1

Beispiele für die Temperaturkompensation der Differenzspannung $u_D$

Fig. 7

$L_S = 3.32\mu H$, $L_E = 1.34\ \mu H$,
$k=0.2588 \to M=546\ nH$
$R_S = 2.7\ \Omega$ (@25°C),  $\alpha=3800\ ppm/K$ (Cu)
C1 = 1.5 nF
C2 = variabel
$i_1 = 1\ mA$

EP 2 309 646 B1

Fig. 8

Beispiel 1

C2 = 7.65 nF
v = 0.164

$u_D$ / V

0,025
0,020
0,015
0,010
0,005
0,000

$u_{sk}$ / V

1,2
0,8
0,4
0,0

f / MHz

2,0   2,2   2,4   2,6   2,8   3,0

Usk @ -25°C
Usk @ 25°C
Usk @ 75°C

Ud @ 75°C
Ud @ 25°C
Ud @ -25°C

Temperaturkompensation bei Amplitudenresonanz

Fig. 9

Temperaturkompensation auf den Flanken

EP 2 309 646 B1

$$v = \frac{L_{S2} + k\sqrt{L_{S1}L_{S2}}}{L_{S1} + L_{S2} + 2k\sqrt{L_{S1}L_{S2}}}$$

$(k = \text{Kopplung } L_{S1}, L_{S2})$

**Fig. 10**

$$v = v_u \frac{L_{S2} + k\sqrt{L_{S1}L_{S2}}}{L_{S1} + L_{S2} + 2k\sqrt{L_{S1}L_{S2}}}$$

$v_u$ optional abgleichbar

**Fig. 11**

**IN DER BESCHREIBUNG AUFGEFÜHRTE DOKUMENTE**

**In der Beschreibung aufgeführte Patentdokumente**

- DE S1286099 A
- EP 0479078 A
- US 6657323 B
- DE 19611810 A1
- DE 19843749 A1